# EUROPÄISCHE PATENTSCHRIFT

(11) **EP 2 614 590 B1**
(45) Veröffentlichungstag und Bekanntmachung des Hinweises auf die Patenterteilung: **16.05.2018**
(21) Anmeldenummer: 11754337.1
(22) Anmeldetag: 26.08.2011
(51) Int. Cl.: H03K 17/96, H03K 17/955

(54) **INSULATING GLASS PANE WITH CAPACITIVE SENSOR**
ISOLIERGLASSCHEIBE MIT KAPAZITIVEM SENSOR
VITRE ISOLANT EN PANNEAU AVEC CAPTEUR CAPACITIF

(30) Priorität: 07.09.2010 DE 102010037370
(43) Veröffentlichungstag der Anmeldung: 17.07.2013
(73) Patentinhaber: Saint-Gobain Glass France, 92400 Courbevoie (FR)
(72) Erfinder: KLEITSCH, Michael, 50997 Köln (DE); GRIGO, Uwe, 51143 Köln (DE)
(74) Vertreter: Gebauer, Dieter Edmund
(86) Internationale Anmeldenummer: PCT/EP2011/064726
(87) Internationale Veröffentlichungsnummer: WO 2012/031912

(56) Entgegenhaltungen:
- EP-A1- 0 899 882
- EP-A2- 0 856 945
- DE-A1-102004 026 836
- DE-A1-102006 022 965
- DE-B3-102005 028 599
- DE-U1- 20 119 700
- DE-U1-202006 006 192

## Beschreibung

Die Erfindung betrifft eine Isolierglasscheibe mit kapazitivem Sensor. Die Erfindung betrifft außerdem ein Verfahren zur Herstellung einer derartigen Isolierglasscheibe mit kapazitivem Sensor sowie deren Verwendung.

In Gebäuden und Verkehrsmitteln, wie Bussen und Bahnen, werden immer häufiger großflächige Verglasungen im Türbereich eingesetzt. Aus Gründen der Energieeinsparung und des Komforts werden an diese Verglasungen hohe Anforderungen bezüglich ihrer wärmeisolierenden Eigenschaften gestellt. Es kommen hauptsächlich Mehrscheiben-Isoliergläser zum Einsatz, bei denen mehrere Glasscheiben über Abstandhalter miteinander verbunden sind und die Wärmedurchgangskoeffizienten von U ≤ 2 W/m²K aufweisen.

Die Türverglasungen werden üblicherweise durch eine Mechanik oder Pneumatik bewegt, welche durch Taster gesteuert werden. Die Taster werden üblicherweise auf den Glasscheiben montiert oder in einer Öffnung oder Aussparung der Glasscheibe befestigt. Die Taster basieren üblicherweise auf kapazitiven Sensoren, da diese keine beweglichen Teile aufweisen und nahezu wartungsfrei sind. Schaltungsanordnungen für kapazitive Schalter mit Kapazitäts-/Spannungswandlern und Oszillationsverfahren sind beispielsweise aus DE 20 2006 006 192 U1 und EP 0 899 882 A1 bekannt.

Ein herkömmlicher kapazitiver Schalter umfasst eine Flächenelektrode, die durch eine dünne Isolatorschicht abgedeckt ist. Über eine Schaltungsanordnung wird die Kapazität der Flächenelektrode gemessen. Die Kapazität der Flächenelektrode ändert sich gegen Erde, wenn ein geerdeter Körper in ihre Nähe kommt oder die Isolatorschicht über der Flächenelektrode berührt. Die Kapazitätsänderung wird gemessen und bei Überschreiten eines Schwellwerts wird ein Schaltsignal ausgelöst.

Herkömmliche kapazitive Schalter in Verglasungen von Verkehrsmitteln befinden sich üblicherweise auf einer der Außenseiten des Scheibenverbunds oder in Öffnungen oder Aussparungen der Scheiben. Alternativ kann der kapazitive Schalter hinter einer Scheibe befestigt sein, so dass die Flächenelektrode des kapazitiven Schalters flächig an der Scheibe angeordnet ist. Die Tastfläche, also die Größe der Flächenelektrode liegt etwa bei nur 10 cm². Eine Vergrößerung der Flächenelektrode beeinträchtigt die Durchsicht und die optische Erscheinung der Glasscheibe.

DE 102005028599 B3 zeigt einen kapazitiven Sensor, bei dem auf die Unterseite einer Trägerschicht eine transparente Leitungsschicht aufgebracht ist. Zudem ist auf die Leitungsschicht eine Sensorschicht 109 aus Aluminium aufgedampft. Die Leitungsschicht und die Sensorschicht bilden gemeinsam eine Kondensatorplatte. Ein Leitgummi kontaktiert die Leitungsschicht am Rand und verbindet diese mit einer Platine 134. Die Platine ist mit einer nicht dargestellten Steuereinheit verbunden, in der das die kapazitive Änderung angebende elektrische Signal der Sensorschicht verarbeitet wird.

DE 20119700 U1 zeigt einen kapazitiven Sensor, bei dem auf die Unterseite einer Blende ein mit einem Ausschnitt versehener Dekorationsdruck aufgebracht ist. Zudem ist hierauf ein Sensorelement aufgebracht, das gleichermaßen mit einem Ausschnitt versehen ist. Das Sensorelement ist über ein Kontaktteil mit einer Leiterplatte elektrisch verbunden, die ihrerseits mit einer Steuerung elektrisch verbunden ist.

EP0856945 A2 zeigt die Verwendung einer auf eine Scheibe aufgebrachten elektrisch leitfähigen Schicht als Elektrode eines Kondensators eines Näherungssensors oder Berührungsschalters.

Die Aufgabe der vorliegenden Erfindung besteht darin, eine Isolierglasscheibe mit kapazitivem Sensor bereitzustellen, die gute wärmeisolierende Eigenschaften bei großflächiger Transparenz aufweist und über eine Tastfunktion auf einem großen Flächenanteil der Scheibe verfügt.

Die Aufgabe der vorliegenden Erfindung wird erfindungsgemäß durch eine Isolierglasscheibe mit kapazitivem Sensor gemäß Anspruch 1 gelöst. Bevorzugte Ausführungen gehen aus den Unteransprüchen hervor.

Ein Verfahren zur Herstellung einer Isolierglasscheibe mit kapazitivem Sensor gehen aus weiteren Ansprüchen hervor.

Die erfindungsgemäße Isolierglasscheibe mit kapazitivem Sensor umfasst mindestens
- eine erste Scheibe und eine zweite Scheibe, die mit einem hohlen Zwischenraum miteinander verbunden sind und Abstandshalter enthalten,
- mindestens eine transparente, elektrisch leitfähige Schicht, die mindestens teilweise und mindestens auf einer der Innenseiten der Scheiben angebracht ist und
- mindestens eine Schaltungsanordnung für einen kapazitiven Schalter zwischen den Scheiben angebracht ist, wobei
- die mindestens eine transparente, elektrisch leitfähige Schicht mit der Schaltungsanordnung für den kapazitiven Schalter elektrisch leitend verbunden ist.

In der erfindungsgemäßen Isolierglasscheibe mit kapazitivem Sensor ist die transparente, elektrisch leitfähige Schicht mit der Schaltungsanordnung für den kapazitiven Schalter galvanisch oder kapazitiv verbunden.

Die Scheibe enthält bevorzugt vorgespanntes, teilvorgespanntes oder nichtvorgespanntes Glas, besonders bevorzugt Flachglas, Floatglas, Quarzglas, Borosilikatglas, Kalk-Natron-Glas, oder klare Kunststoffe, vorzugsweise starre klare Kunststoffe, insbesondere Polyethylen, Polypropylen, Polycarbonat, Polymethylmethacrylat, Polystyrol, Polyamid, Polyester, Polyvinylchlorid und/oder Gemische davon. Beispiele geeigneter Gläser sind aus DE 697 31 268 T2, Seite 8, Absatz [0053] bekannt. Die erste und/oder die zweite Scheibe können auch als Verbundsicherheitsscheibe ausgebildet sein. Eine Verbundsicherheitsscheibe enthält zwei oder mehr Scheiben, die mit mindestens einer Zwischenschicht miteinander verbunden sind. Die Zwischenschichten enthalten vorzugsweise thermoplastische Kunststoffe, wie Polyvinylbutral (PVB) oder Ethylenvinylacetat (EVA) oder mehrere Schichten davon, bevorzugt mit Dicken von 0,3 mm bis 0,8 mm.

Die Dicke der Scheiben kann breit variieren und so hervorragend den Erfordernissen des Einzelfalls angepasst werden. Scheiben werden bevorzugt mit den Standardstärken von 1,0 mm bis 10 mm und besonders bevorzugt von 3 mm bis 7 mm verwendet. Die Größe der Scheiben kann breit variieren, beispielsweise von 0,4 m x 0,4 m bis 3,2 m x 6 m.

Die Scheiben können eine beliebige dreidimensionale Form aufweisen. Die dreidimensionale Form hat vorzugsweise keine Schattenzonen, so dass sie beispielsweise durch Kathodenzerstäubung mit der transparenten, elektrisch leitfähigen Schicht beschichtet werden können. Die Substrate sind bevorzugt planar oder leicht oder stark in einer Richtung oder in mehreren Richtungen des Raumes gebogen. Insbesondere werden planare Substrate verwendet. Die Scheiben können farblos oder getönt sein, bevorzugt grau oder grün.

In einer bevorzugten Ausführungsform der erfindungsgemäßen Verbundscheibe enthält mindestens eine der Scheiben Glas und mindestens eine der Scheiben enthält Kunststoff. Insbesondere bei einer erfindungsgemäßen Verwendung als Fahrzeugscheibe enthält die dem Fahrzeuginnenraum zugewandte Scheibe einen Kunststoff und die dem Fahrzeugaußenraum zugewandte Scheibe Glas.

Beide Scheiben werden durch einen Abstandshalter aus Metall, bevorzugt aus Aluminium oder Edelstahl, oder durch einen Kunststoff in einem festen Abstand zueinander gehalten. Die Abstandshalter weisen bevorzugt ein U-förmiges Profil auf und bestehen aus einem oder mehreren Elementen. Alternativ kann das Gehäuse der Schaltungsanordnung für den kapazitiven Schalter als Abstandshalter dienen. Der Abstand zwischen der ersten und der zweiten Scheibe beträgt bevorzugt von 5 mm bis 20 mm, besonders bevorzugt von 10 mm bis 15 mm und kann den Erfordernissen des Einzelfalls angepasst werden.

Der umlaufende Spalt zwischen den beiden Scheiben wird bevorzugt am Rand mit einem Kunststoffmaterial versiegelt, beispielsweise einem Kleber oder einer Dichtschnur auf Basis von Polyvinylbutyral, Polysulfit, Polyurethan, Acryl oder Silikon. Die Versiegelung des Randspalts schützt die korrosionsempfindliche transparente, elektrisch leitfähige Schicht vor Feuchtigkeit. Die Randversiegelung kann auch als Abstandshalter dienen und die Scheiben auf einem definierten Abstand halten.

Der Zwischenraum zwischen beiden Scheiben kann ein Gas oder ein Gasgemisch, enthalten, beispielsweise Luft, getrocknete Luft oder Inertgase wie Argon, Krypton oder Stickstoff.

Üblicherweise wird ein Trocknungsmittel in den Zwischenraum zwischen beiden Scheiben eingebracht. Das Trocknungsmittel ist beispielsweise in einem Hohlraum der Abstandshalter angeordnet. Geeignete Trocknungsmittel für den Einsatz in Isolierglasscheiben sind beispielsweise Silicagele, Zeolithe oder Schichtsilikate. Die Trocknungsmittel können Wasser aufnehmen und physikalisch binden. Durch das Trocknungsmittel wird die Bildung von Wasserdampf im Scheibenzwischenraum verhindert und ein störendes Beschlagen der Scheibe vermieden, wenn durch Unterschreiten der Taupunkttemperatur der Wasserdampf kondensiert. Außerdem wird die korrosionsempfindliche transparente, elektrisch leitfähige Schicht vor Feuchtigkeit geschützt.

Die Isolierglasscheibe mit kapazitivem Sensor weist beispielsweise einen Wärmewiderstandswert U ≤ 2 W/m²K auf, bevorzugt von 0,1 W/m²K bis 0,7 W/m²K.

Mindestens eine der Scheiben der erfindungsgemäßen Isolierglasscheibe mit kapazitivem Sensor ist auf einer Innenseite mit einer transparenten, elektrisch leitfähigen Schicht beschichtet. Innenseite oder innenliegende Seite bedeutet hier die Seiten der Scheiben, die jeweils der anderen Scheibe des Scheibenverbunds zugewandt sind.

In einer bevorzugten Ausgestaltung der erfindungsgemäßen Isolierglasscheibe mit kapazitivem Sensor enthält die transparente, elektrisch leitfähige Schicht mindestens ein Metall, bevorzugt Silber, Nickel, Chrom, Niob, Zinn, Titan, Kupfer, Palladium, Zink, Gold, Cadmium, Aluminium, Silizium, Wolfram oder Legierungen daraus, und/oder mindestens ein Metalloxidschicht, bevorzugt Zinn-dotiertes Indiumoxid (ITO), Aluminium-dotiertes Zinkoxid (AZO), Fluor-dotiertes Zinnoxid (FTO, SnO₂:F), Antimon-dotiertes Zinnoxid (ATO, SnO₂:Sb), und/oder Kohlenstoffnanoröhrchen und/oder optisch transparente, elektrisch leitfähige Polymere, bevorzugt Poly(3,4-ethylenedioxythiophene), Polystyrensulfonat, Poly(4,4-dioctylcylopentadithiophen), 2,3-Dichloro-5,6-dicyano-1,4-benzoquinon, Gemische und/oder Copolymere davon.

Die erfindungsgemäße transparente, elektrisch leitfähige Schicht ist für elektromagnetische Strahlung, vorzugsweise elektromagnetische Strahlung einer Wellenlänge von 300 nm bis 1.300 nm, insbesondere für sichtbares Licht, durchlässig. "Durchlässig" bedeutet, dass die Transmission der transparenten, elektrisch leitfähigen Schicht bevorzugt >50% und insbesondere >70% ist. Für die Verwendung der Isolierglasscheibe mit kapazitivem Sensor als Fahrzeugverglasung muss die Gesamttransmission des Scheibenverbunds den gesetzlichen Bestimmungen entsprechen.

Solche transparenten, elektrisch leitfähige Schichten sind aus DE 20 2008 017 611 U1 und EP 0 847 965 B1 bekannt. Sie bestehen beispielsweise aus einer Metallschicht wie einer Silberschicht oder einer Schicht aus einer silberhaltigen Metalllegierung. Typische Silberschichten weisen bevorzugt Dicken von 5 nm bis 15 nm auf, besonders bevorzugt von 8 nm bis 12 nm. Die Metallschicht kann zwischen mindestens zwei Schichten aus dielektrischem Material vom Typ Metalloxid eingebettet sein. Das Metalloxid enthält bevorzugt Zinkoxid, Zinnoxid, Indiumoxid, Titanoxid, Siliziumoxid, Aluminiumoxid oder dergleichen sowie Kombinationen von einem oder mehreren daraus. Das dielektrische Material kann auch Siliziumnitrid, Siliziumcarbid oder Aluminiumnitrid enthalten.

Bevorzugt werden Metallschichtsysteme mit mehreren Schichten verwendet, wobei die einzelnen Metallschichten durch mindestens eine Schicht aus dielektrischem Material getrennt sind.

Die Metallschichtsysteme können eine besonders geringe Emissivität für Infrarotstrahlung aufweisen und die langwellige Infrarot-Strahlung großteilig reflektieren. Derartige Metallschichtsysteme werden üblicherweise als niedrig-emissive Beschichtung oder als Low-e-Beschichtung bezeichnet.

Der Schichtaufbau wird im Allgemeinen durch eine Folge von Abscheidevorgängen erhalten, die durch ein Vakuumverfahren wie die magnetfeldgestützte Kathodenzerstäubung oder durch chemische Gasphasenabscheidung (CVD) durchgeführt werden. Auf beiden Seiten der Silberschicht können auch sehr feine Metallschichten vorgesehen werden, die insbesondere Titan oder Niob enthalten. Die untere Metallschicht dient als Haft- und Kristallisationsschicht. Die obere Metallschicht dient als Schutz- und Getterschicht, um eine Veränderung des Silbers während der weiteren Prozessschritte zu verhindern.

Die Dicke der transparenten, elektrisch leitfähigen Schicht kann breit variieren und den Erfordernissen des Einzelfalls angepasst werden.

Die erfindungsgemäß verwendeten transparenten, elektrisch leitfähigen Schichten haben bevorzugt einen Flächenwiderstand von 0,1 Ohm/Quadrat bis 200 Ohm/Quadrat, besonders bevorzugt von 1 Ohm/Quadrat bis 50 Ohm/Quadrat und ganz besonders bevorzugt von 1 Ohm/Quadrat bis 10 Ohm/Quadrat.

Im Falle der Verwendung einer Verbundsicherheitsscheibe als erste und/oder zweite Scheibe kann die transparente, elektrisch leitfähige Schicht im Inneren des Verbundsicherheitsglases oder auf der dem hohlen Zwischenraum zugewandten Seite der Verbundsicherheitsscheibe angeordnet sein.

In einer bevorzugten Ausgestaltung der erfindungsgemäßen Isolierglasscheibe mit kapazitivem Sensor erstreckt sich die transparente, elektrisch leitfähige Schicht auf mindestens 50%, bevorzugt auf mindestens 70% und besonders bevorzugt auf mindestens 90% der Fläche der Seite der Scheibe, auf die sie aufgebracht ist.

Die transparente, elektrisch leitfähige Schicht erstreckt sich bevorzugt über die gesamte Fläche der Seite der Scheibe, auf die sie aufgebracht ist, abzüglich eines umlaufenden rahmenförmigen entschichteten Bereichs mit einer Breite von 2 mm bis 20 mm, bevorzugt von 5 mm bis 10 mm. Dieser dient der elektrischen Isolierung zwischen der transparenten, elektrisch leitfähigen Schicht und dem Rahmen. Außerdem wird eine Korrosion der transparenten, elektrisch leitfähigen Schicht durch von außen in die Schicht eindringende Feuchtigkeit verhindert.

Die Schaltungsanordnung für einen kapazitiven Schalter ist beispielsweise aus DE 20 2005 010 379 U1 bekannt. In einer einfachen Ausführung wird die Kapazität einer Flächenelektrode durch einen Kapazitäts-/Spannungswandler gemessen. Die Flächenelektrode ist beispielsweise durch eine dünne Isolatorschicht abgedeckt, so dass keine Kriechströme die Messung beeinträchtigen. Die Flächenelektrode wird durch die Schaltungsanordnung auf eine vorgegebene Spannung geladen. Der zum Aufladen benötigte Stromfluss wird gemessen und in ein Spannungssignal gewandelt. Anschließend wird die Flächenelektrode entladen und erneut auf die vorgegebene Spannung geladen. Eine Änderung der Kapazität der Flächenelektrode kann durch die Änderung des Spannungssignals gemessen werden. Die Kapazität der Flächenelektrode gegen Erde ändert sich, wenn eine geerdeter Körper, beispielsweise ein Mensch, in ihre Nähe kommt oder sie berührt.

Die Änderungen des Spannungssignals können durch ein Differenzierglied verstärkt und über einen Komparator mit einem Schwellwert verglichen werden. Übersteigt die Änderung des Spannungssignals einen Schwellwert gibt der Komparator ein Ausgangssignal aus. Das Ausgangssignal wird vorzugsweise einer weiteren Steuerelektronik zugeführt, die auf den jeweiligen Einsatzzweck abgestimmt ist. Die Steuerelektronik kann beispielsweise einen Mechanismus zum Öffnen oder Schließen einer Tür auslösen.

Eine Kapazitätsänderung kann nach dem Stand der Technik auch durch einen nicht schwingenden Oszillator erfasst werden, der durch die Kapazitätsänderung zum Anschwingen gebracht wird. Alternativ kann ein schwingender Oszillator so stark bedämpft werden, dass seine Schwingung abreißt. Eine Schaltungsanordnung mit Oszillator ist beispielsweise aus EP 0 899 882 A1 bekannt.

In der erfindungsgemäßen Isolierglasscheibe mit kapazitivem Sensor wird eine Schaltungsanordnung für einen kapazitiven Schalter galvanisch mit der transparenten, elektrisch leitfähigen Schicht verbunden. Bei Berühren der Außenseite der Scheibe durch einen geerdeten menschlichen Körper, beispielsweise durch eine Hand, ändert sich die Kapazität der transparenten, elektrisch leitfähigen Schicht gegen Erde. Die Kapazitätsänderung wird durch die Schaltungsanordnung für einen kapazitiven Schalter gemessen und bei Überschreiten eines Schwellwerts wird ein Schaltsignal ausgelöst. Das Schaltsignal wird durch die mehradrige Zuleitung einer externen Steuerelektronik zugeführt.

In einer alternativen Ausgestaltung der erfindungsgemäßen Isolierglasscheibe mit kapazitivem Sensor wird die Flächenelektrode einer Schaltungsanordnung für einen kapazitiven Schalter kapazitiv mit der transparenten, elektrisch leitfähigen Schicht gekoppelt. Dabei wird die dünne Flächenelektrode der Schaltungsanordnung flächig neben der transparenten, elektrisch leitfähigen Schicht angeordnet. Die Flächenelektrode weist bevorzugt eine Fläche von 1 cm² bis 100 cm² auf und insbesondere von 5 cm² bis 15 cm², beispielsweise in Form einer Kreisscheibe. Der Abstand zwischen Flächenelektrode und transparenter, elektrisch leitfähiger Schicht beträgt etwa von 0,01 mm bis 5 mm, bevorzugt von 0,2 mm bis 1 mm. Üblicherweise ist die Flächenelektrode mit einer Isolatorschicht bedeckt, beispielsweise einer isolierenden Kunststofffolie. Außerdem kann die transparente, elektrisch leitfähige Schicht mit einer dielektrischen Schicht vor Korrosion geschützt sein. Sowohl Isolatorschicht als auch dielektrische Schicht verhindern einen galvanischen Kontakt. Aufgrund des geringen Abstandes und der flächenmäßigen Ausdehnung von Flächenelektrode und transparenter, elektrisch leitfähiger Schicht findet eine kapazitive Kopplung statt.

In einer vorteilhaften Ausgestaltung der erfindungsgemäßen Isolierglasscheibe mit kapazitivem Sensor weist die transparente, elektrisch leitfähige Schicht mindestens zwei voneinander elektrisch isolierte Bereiche auf, die mit jeweils einer Schaltungsanordnung für einen kapazitiven Schalter galvanisch oder kapazitiv verbunden sind. Alternativ können mehrere voneinander elektrisch isolierte Bereiche mit jeweils einer gemeinsamen Schaltungsanordnung verbunden sein, beispielsweise wenn zwei elektrisch isolierte Bereiche auf den zwei Innenseiten der Scheiben angeordnet sind. Die voneinander elektrisch isolierten Bereiche können als getrennte elektrisch isolierte Bereiche, beispielsweise durch Maskierungstechniken aufgebracht werden. Alternativ kann eine elektrisch leitfähige Schicht aufgebracht werden, die durch Einschnitte getrennt wird, beispielsweise durch Laserschneiden oder mechanisches Abtragen.

Die Schaltungsanordnung für einen kapazitiven Schalter ist beispielsweise über eine mehradrige Zuleitung mit einer Spannungsversorgung und einer externen Steuerungselektronik verbunden. Die Zuleitung wird durch den Abstandhalter hindurch oder am Abstandhalter vorbei und durch die Randversiegelung aus dem Zwischenraum zwischen beiden Scheiben herausgeführt.

In einer bevorzugten Ausgestaltung der erfindungsgemäßen Isolierglasscheibe mit kapazitivem Sensor können die Zuleitungen sehr dünne und optisch kaum wahrnehmbare Kabel oder Drähte im Zwischenraum zwischen den beiden Scheiben umfassen. Die Zuleitungen können durch Aufdrucken einer leitfähigen Paste auf beschichtungsfreie Bereiche der Scheiben hergestellt werden. Die leitfähige Paste wird auf die Scheibe eingebrannt und enthält bevorzugt Silber-Partikel und Glasfritten. Die Schichtdicke der eingebrannten Silber-Paste beträgt insbesondere von 5 µm bis 20 µm.

In einer bevorzugten Ausgestaltung der erfindungsgemäßen Scheibe wird der Randbereich und/oder der Bereich, in dem die Zuleitungen geführt werden, durch einen Abdeckdruck auf den Innen- und/oder Außenseiten der Scheiben abgedeckt, so dass sie von außen nicht sichtbar sind. Auf den Innen- und Außenseiten können weitere Beschriftungen oder Symbole aufgedruckt, aufgeklebt oder anderweitig angeordnet sein.

In einer bevorzugten Ausgestaltung der erfindungsgemäßen Scheibe werden Spannungsversorgung und Steuersignale durch isolierte Bereiche der transparenten, elektrisch leitfähigen Schicht, bevorzugt durch einzelne parallel verlaufende Leiterbahnen geführt. Der Anschluss der Leiterbahnen an die externe Steuerelektronik oder weiterführende Zuleitungen erfolgt dann im Randbereich der Scheibe. Die Breite der Leiterbahnen kann den Erfordernissen des Einzelfalls angepasst werden und richtet sich nach dem Flächenwiderstand der transparenten, elektrisch leitfähigen Schicht sowie dem Abstand zwischen der Schaltungsanordnung für den kapazitiven Schalter und dem Scheibenrand.

Die Erfindung umfasst außerdem ein Verfahren zur Herstellung einer Isolierglasscheibe mit kapazitivem Sensor, wobei mindestens
- in einem ersten Schritt eine erste Scheibe und/oder zweite Scheibe mit einer transparenten, elektrisch leitfähigen Schicht beschichtet wird,
- in einem zweiten Schritt eine Schaltungsanordnung für einen kapazitiven Schalter mit der transparenten, elektrisch leitfähigen Schicht galvanisch oder kapazitiv verbunden wird,
- in einem dritten Schritt die zweite Scheibe mit der ersten Scheibe auf einem definierten Abstand gehalten wird, wobei die Schaltungsanordnung zwischen der ersten Scheibe und der zweiten Scheibe angeordnet wird und
- in einem vierten Schritt der umlaufende Spalt zwischen der ersten Scheibe und der zweiten Scheibe mit einer Randversiegelung versiegelt wird.

In einer vorteilhaften Ausführungsform des erfindungsgemäßen Verfahrens wird im ersten Schritt eine Innenseite einer der Scheiben mit einer transparenten, elektrisch leitfähigen Schicht beschichtet.

In einer weiteren vorteilhaften Ausführungsform des erfindungsgemäßen Verfahrens wird im zweiten Schritt das Gehäuse der Schaltungsanordnung für den kapazitiven Schalter und die transparente, elektrisch leitfähige Schicht durch Verkleben verbunden.

In einer vorteilhaften Ausführungsform des erfindungsgemäßen Verfahrens wird im dritten Schritt die zweite Scheibe mit der ersten Scheibe über Abstandhalter, bevorzugt über U-profilförmige Abstandshalter auf einem definierten Abstand gehalten und im vierten Schritt der äußere Hohlraum durch die Randversiegelung gefüllt. Der äußere Hohlraum ist der Raum zwischen den beiden Scheiben, der zwischen dem Abstandshalter und dem Seitenrand der Scheiben verbleibt.

Die Erfindung umfasst außerdem die Verwendung der Isolierglasscheibe mit kapazitivem Sensor als funktionales und/oder dekoratives Einzelstück und/oder als Einbauteil in Möbeln und Geräten, insbesondere elektronischen Geräten mit Kühl- oder Heizfunktion, zur Verglasung von Gebäuden, insbesondere im Zugangs- oder Fensterbereich, oder zur Verglasung in einem Fahrzeug für den Verkehr auf dem Lande, in der Luft oder zu Wasser, insbesondere in Kraftfahrzeugen, beispielsweise als Fahrzeugtür. Eine besonders bevorzugte Verwendung der Isolierglasscheibe mit kapazitivem Sensor is in Bussen, Straßenbahnen, U-Bahnen und Zügen zur Personenbeförderung und für den öffentlichen Nah- und Fernverkehr.

Im Folgenden wird die Erfindung anhand einer Zeichnung näher erläutert. Die Zeichnung ist eine schematische Darstellung und nicht maßstabsgetreu. Die Zeichnung schränkt die Erfindung in keiner Weise ein.

Es zeigen:
Figur 1A eine Draufsicht auf eine erfindungsgemäße Isolierglasscheibe mit kapazitivem Sensor,
Figur 1B eine Querschnittszeichnung entlang der Schnittlinie A-A' in Figur 1A,
Figur 2 eine Querschnittszeichnung entlang der Schnittlinie A-A' in Figur 1A einer alternativen Ausgestaltung der erfindungsgemäßen Isolierglasscheibe mit kapazitivem Sensor,
Figur 3A eine Draufsicht auf die Vorderseite einer erfindungsgemäßen Isolierglasscheibe mit kapazitivem Sensor,
Figur 3B eine Draufsicht auf die Rückseite einer erfindungsgemäßen Isolierglasscheibe mit kapazitivem Sensor und
Figur 3C eine Querschnittszeichnung entlang der Schnittlinie B-B' in Figur 3A.

In den folgenden Figuren ist eine Ausführung der erfindungsgemäßen Isolierglasscheibe mit kapazitivem Sensor dargestellt.

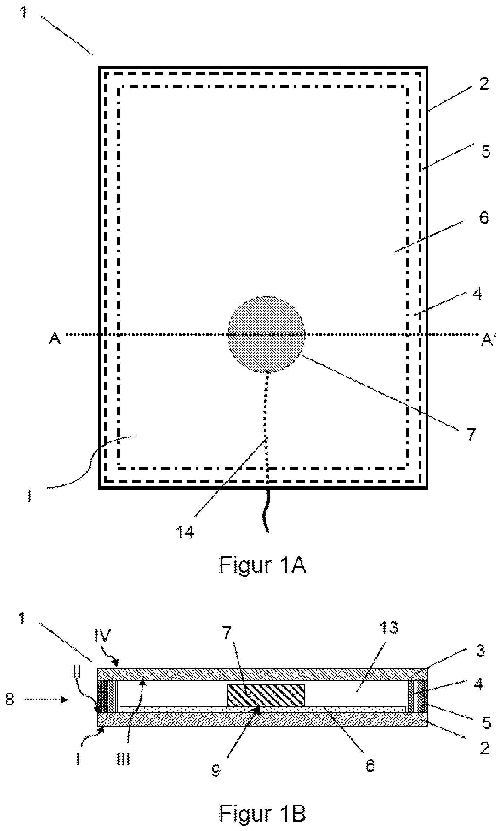

In Figur 1A ist eine Isolierglasscheibe 1 mit kapazitivem Sensor mit einer Schaltungsanordnung für einen kapazitiven Schalter 7 dargestellt, wobei die Schaltungsanordnung 7 galvanisch mit der transparenten, elektrisch leitfähigen Schicht 6 verbunden ist. In Figur 1B ist eine Querschnittszeichnung entlang der Schnittlinie A-A' aus Figur 1A dargestellt.

Die erste Scheibe 2 und die zweite Scheibe 3 bestehen beispielsweise aus vorgespanntem Glas und weisen eine Dicke von beispielsweise 4 mm auf. Die erste Scheibe 2 und die zweite Scheibe 3 weisen beispielsweise Flächen von 1 m x 2,5 m auf. Die transparente, elektrisch leitfähige Schicht 6 ist auf der Innenseite (II) der ersten Scheibe 2 angeordnet. Die transparente, elektrisch leitfähige Schicht 6 enthält beispielsweise eine 9 nm dicke transparente Silberschicht.

Im Herstellungsprozess wird die transparente, elektrisch leitfähige Schicht 6 in der Regel auf die gesamte Innenseite (II) der Scheibe 2 abgeschieden. In einem zweiten Verfahrensschritt erfolgt die Entschichtung eines Randbereichs, beispielsweise mittels Laserablation, Plasmaätzen oder mechanischen Verfahren.

Beide Scheiben 2, 3 werden durch einen umlaufenden Abstandshalter 4, beispielsweise ein Aluminiumhohlprofil, auf einen festen Abstand von beispielsweise 14 mm gehalten. Beide Scheiben 2, 3 sind mit dem Aluminiumhohlprofil verklebt, beispielsweise mittels eines Klebers auf Polyvinybutyral-Basis. Der Spalt 8 zwischen der ersten Scheibe 2 und der zweiten Scheibe 3 ist im äußeren Hohlraum, also im Raum zwischen Abstandhalter 4 und Seitenrand der Scheiben durch eine Randversiegelung versiegelt. Die Randversiegelung erfolgt beispielsweise durch einen Kleber oder eine Dichtschnur aus Polyvinylsulfid. Im Abstandshalter kann zusätzlich ein Trocknungsmittel angeordnet sein, beispielsweise Silicagel. Das Trockungsmittel bindet Feuchtigkeit aus dem Zwischenraum zwischen beiden Scheiben 2, 3 und schützt so die transparente, elektrisch leitfähige Schicht 6 vor Korrosion.

Die Schaltungsanordnung für einen kapazitiven Schalter 7 ist über die Kontaktfläche 9 galvanisch mit der transparenten, elektrisch leitfähigen Schicht 6 verbunden. Die galvanische Verbindung erfolgt beispielsweise durch Klemmen oder Kleben mit einem elektrisch leitfähigen Kleber.

Die Schaltungsanordnung für einen kapazitiven Schalter 7 ist über eine mehradrige Zuleitung 14 mit einer Spannungsversorgung und einer externen Steuerungselektronik verbunden. Die Zuleitung 14 wird durch den Abstandhalter und durch die Randversiegelung aus dem Zwischenraum zwischen beiden Scheiben 2, 3 herausgeführt. Die Schaltungsanordnung für einen kapazitiven Schalter 7 wird beispielsweise mit eine Betriebsspannung von 12 V oder 24 V betrieben.

Bei Berühren der Außenseite (I) der ersten Scheibe 2 durch einen menschlichen Körper, beispielsweise durch eine Hand, ändert sich die Kapazität der transparenten, elektrisch leitfähigen Schicht 6 gegen Erde. Die Kapazitätsänderung wird durch die Schaltungsanordnung für einen kapazitiven Schalter 7 gemessen und bei Überschreiten eines Schwellwerts wird ein Schaltsignal ausgelöst. Das Schaltsignal wird durch die mehradrige Zuleitung 14 einer externen Steuerelektronik zugeführt und dort weiterverwendet.

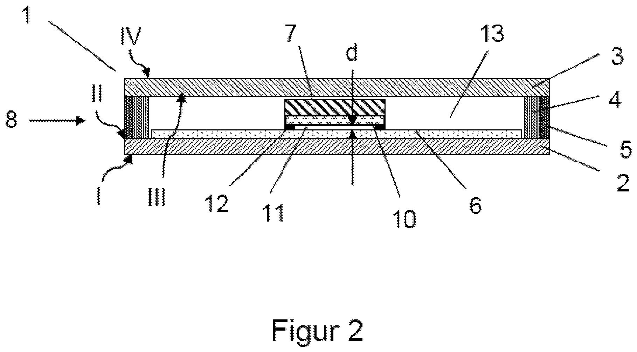

In Figur 2 ist eine Querschnittszeichnung einer alternativen Ausgestaltung der erfindungsgemäßen Isolierglasscheibe 1 mit kapazitivem Sensor entlang der Schnittlinie A-A' aus Figur 1A dargestellt. Die Schaltungsanordnung für den kapazitiven Schalter 7 weist eine Flächenelektrode 10 auf. Die Flächenelektrode 10 ist über ein Beabstandungsmittel in Form eines Distanzrings 12 mit einem festen Abstand d von beispielsweise 0,5 mm zur transparenten, elektrisch leitfähigen Schicht 6 angeordnet. Der Distanzring 12 besteht aus einem elektrisch isolierenden Material, beispielsweise aus einem Kunststoff wie Polycarbonat. Zwischen der Flächenelektrode 10 und der transparenten, elektrisch leitfähigen Schicht 6 verbleibt ein Spalt 11. Durch die parallele und elektrisch isolierte Anordnung der Flächenelektrode 10 zur transparenten, elektrisch leitfähigen Schicht 6 erfolgt eine kapazitive Kopplung.

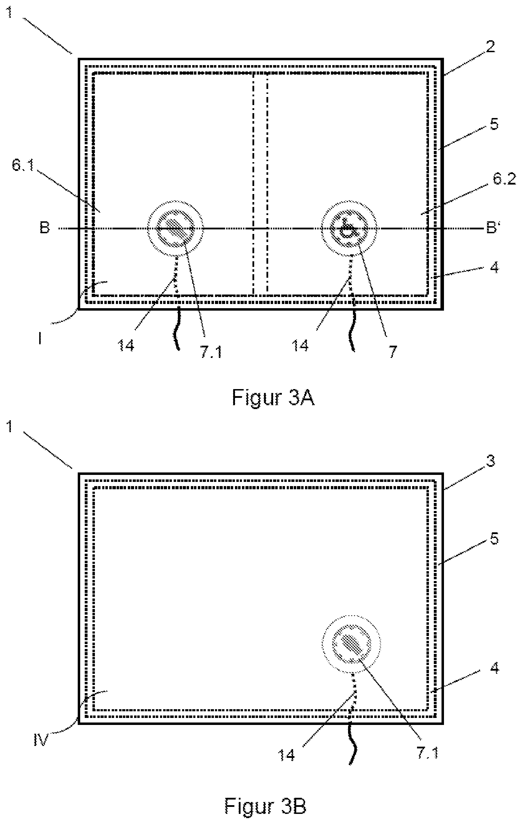

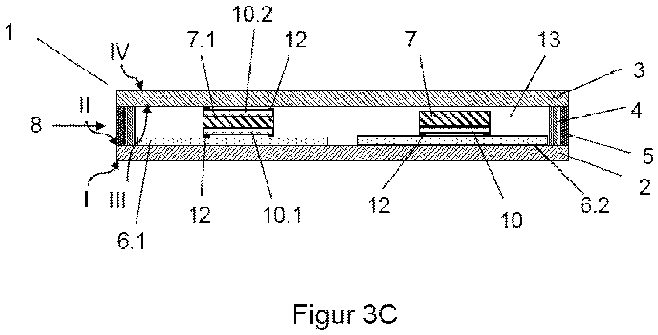

In einem weiteren Beispiel ist eine erfindungsgemäße Isolierglasscheibe 1 mit kapazitivem Sensor am Beispiel einer Tür für ein Verkehrsmittel, beispielsweise einer Strassen- oder U-Bahntür ausgeführt. Figur 3A zeigt eine Draufsicht auf die Vorderseite der Isolierglasscheibe 1 mit kapazitivem Sensor, das heißt auf die Außenseite (I) der ersten Scheibe 2. Figur 3B zeigt eine Draufsicht auf die Rückseite der Isolierglasscheibe 1 mit kapazitivem Sensor, das heißt auf die Außenseite (IV) der zweiten Scheibe 3. In Figur 3C ist eine Querschnittszeichnung entlang der Schnittlinie B-B' aus Figur 3A dargestellt.

Die erste Scheibe 2 umfasst eine Glasscheibe mit einer transparenten, elektrisch leitfähigen Schicht 6 auf der Innenseite (II) der Scheibe 2 in Form einer sogenannten niedrig-emissiven Beschichtung. Die Scheibe 2 ist beispielsweise ein beschichtetes niedrig-emissives, farblich neutrales Glas, SSG Planitherm® von Saint-Gobain Glass mit einer Dicke von 4 mm und einem U-Wert von 1,2 W/m²K. Die niedrig-emissive Schicht emittiert langwellige infrarote Strahlung und enthält eine Silberschicht, die zwischen mehreren Metalloxid- und Metallnitrid-Schichten eingebettet ist. Die zweite Scheibe 3 ist ein in der Masse gefärbtes Glas, SGG Parsol von Saint-Gobain Glass mit einer Dicke von 4 mm. Aufgrund ihrer Verwendung in einem Verkehrsmittel bestehen beide Scheiben 2, 3 aus vorgespanntem Einscheiben-Sicherheitsglas. Beide Scheiben 2, 3 weisen beispielsweise eine Höhe von 2,2 m und eine Breite von 3,6 m auf und werden über Abstandshalter 4 auf einen festen Abstand von 14 mm gehalten. Der umlaufende Randspalt zwischen der ersten Scheibe 2 und der zweiten Scheibe 3 ist versiegelt. Der Zwischenraum zwischen beiden Scheiben 2, 3 ist mit Luft gefüllt. Die Isolierglasscheibe 1 mit kapazitivem Sensor weist beispielsweise einen Wärmedurchgangskoeffizienten von weniger als 1,1 W/m²K auf.

Die transparente, elektrisch leitfähige Schicht 6 auf der Innenseite (II) der ersten Scheibe 2 ist durch mechanisches Abtragen in zwei voneinander elektrisch isolierte Bereiche 6.1, 6. 2 getrennt.

Im Bereich 6.2 ist eine Schaltungsanordnung für einen kapazitiven Schalter 7 vom Typ CHT6 der Firma CAPTRON Electronic GmbH, Olching, Deutschland angeordnet. Das Gehäuse der Schaltungsanordnung 7 ist über einen Distanzring 12 mit der transparenten, elektrisch leitfähigen Schicht 6 im Bereich 6.2 verklebt. Über die Flächenelektrode 10 der Schaltungsanordnung 7 erfolgt eine kapazitive Leitungsverbindung zur transparenten, elektrisch leitenden Schicht 6 im Bereich 6.2.

Im Bereich 6.1 ist eine Doppelausführung der Schaltungsanordnung für einen kapazitiven Schalter 7.1 vom Typ CHT5 der Firma CAPTRON Electronic GmbH, Olching, Deutschland angeordnet. Die Schaltungsanordnung CHT5 umfasst eine erste Flächenelektrode 10.1 auf der Vorderseite und eine zweite Flächenelektrode 10.2 auf der Rückseite des Gehäuses. Das Gehäuse der Schaltungsanordnung 7.1 ist über Distanzringe 12 sowohl mit der transparenten, elektrisch leitfähigen Schicht 6 im Bereich 6.1 auf der Innenseite (II) der ersten Scheibe 2 als auch mit der Innenseite (III) der zweiten Scheibe 3 verklebt. Über die Flächenelektrode 10.1 der Schaltungsanordnung 7.1 erfolgt eine kapazitive Leitungsverbindung zur transparenten, elektrisch leitenden Schicht 6 im Bereich 6.1.

Die Schaltvorgänge der Doppelausführung der Schaltungsanordnung 7.1 können durch zwei Ereignisse ausgelöst werden:
- durch Berühren der Außenfläche (I) der Scheibe 2 über dem Bereich 6.1 der transparenten, elektrisch leitfähigen Schicht 6 und
- durch Berühren der Außenfläche (IV) der Scheibe 3 über dem Bereich der Flächenelektrode 10.2.

Durch die erfindungemäße Isolierglasscheibe 1 mit kapazitivem Sensor ergibt sich eine Reihe von Vorteilen im Vergleich zu Scheiben mit Tastern nach dem Stand der Technik. So müssen die Scheiben 2, 3 zur Installation eines kapazitiven Schalters nicht mehr durchbohrt oder durchbrochen werden. Die ist bei vorgespannten oder teilvorgespannten Glasscheiben von besonderem Vorteil, da diese Glasscheiben nach dem Vorspannen nicht mehr gebohrt oder geschliffen werden können. Die geschlossene Oberfläche der Glasscheibe ist widerstandfähiger gegen Umwelteinflüsse, Reinigungsmittel und Vandalismus, beispielsweise Graffitis, als Glasscheiben mit hervorstehenden Aufbauten. Die Bedienfläche kann auf die gesamte Scheibenfläche ausgedehnt werden. Die Schaltungsanordnung für den kapazitiven Schalter 7 kann innerhalb des Scheibenverbundes frei positioniert werden und schraubenlos, beispielsweise durch Kleben befestigt werden.

Diese Vorteile waren für den Fachmann überraschend und unerwartet.

### Bezugszeichenliste:

- 1: Isolierglasscheibe mit kapazitivem Sensor
- 2: erste Scheibe
- 3: zweite Scheibe
- 4: Abstandshalter
- 5: Randversiegelung
- 6: transparente, elektrisch leitende Schicht
- 6.1,6.2: Bereich von 6
- 7: Schaltungsanordnung für einen kapazitiven Schalter
- 7.1: Doppelausführung der Schaltungsanordnung für einen kapazitiven Schalter
- 8: Spalt zwischen erster Scheibe 2 und zweiter Scheibe 3
- 9: Kontaktfläche zwischen 6 und 7
- 10, 10.1, 10.2: Flächenelektrode
- 11: Spalt zwischen 6 und 10
- 12: Distanzring
- 13: hohler Zwischenraum
- 14: Zuleitung
- I: Außenseite der ersten Scheibe 2
- II: Innenseite der ersten Scheibe 2
- III: Innenseite der zweiten Scheibe 3
- IV: Außenseite der zweiten Scheibe 3
- A-A': Schnittlinie
- B-B': Schnittlinie
- d: Abstand zwischen 6 und 10

## Patentansprüche

1. Isolierglasscheibe (1) mit einem kapazitiven Schalter, umfassend:
- eine erste Scheibe (2) und eine zweite Scheibe (3), die miteinander verbunden sind,
wobei die beiden Scheiben (2, 3) über Abstandshalter (4) auf Abstand gehalten werden,
wobei sich zwischen beiden Scheiben (2, 3) ein hohler Zwischenraum (13) befindet,
- mindestens eine transparente, elektrisch leitfähige Schicht (6), die mindestens teilweise und mindestens auf einer der jeweils der anderen Scheibe (2, 3) zugewandten Innenseiten (II, III) der ersten Scheibe (2) oder der zweiten Scheibe (3) angebracht ist, und
- mindestens eine Schaltungsanordnung (7), die zwischen der ersten Scheibe (2) und der zweiten Scheibe (3) angebracht ist,
wobei die Schaltungsanordnung (7) zur Formung des kapazitiven Schalters mit der transparenten, elektrisch leitfähigen Schicht (6) galvanisch verbunden ist oder durch eine Flächenelektrode (10) mit der transparenten, elektrisch leitfähigen Schicht (6) kapazitiv gekoppelt ist, wobei die Schaltungsanordnung (7) eine Kapazitätsänderung gegen Erde der transparenten, elektrisch leitfähigen Schicht (6) messen und bei Überschreiten eines Schwellwerts ein Schaltsignal auslösen kann.

2. Isolierglasscheibe (1) nach Anspruch 1, wobei der Zwischenraum (13) ein Gas oder ein Gasgemisch und bevorzugt getrocknete Luft, Argon oder Krypton enthält und der Abstand zwischen der ersten Scheibe (2) und der zweiten Scheibe (3) bevorzugt von 5 mm bis 20 mm und besonders bevorzugt von 10 mm bis 15 mm beträgt.

3. Isolierglasscheibe (1) nach einem der Ansprüche 1 bis 2, wobei eine Randversiegelung (5) den umlaufenden Spalt (8) zwischen der ersten Scheibe (2) und der zweiten Scheibe (3) versiegelt.

4. Isolierglasscheibe (1) nach einem der Ansprüche 1 bis 3, wobei die erste Scheibe (2) und/oder die zweite Scheibe (3) vorgespanntes, teilvorgespanntes oder nichtvorgespanntes Glas, besonders bevorzugt Flachglas, Floatglas, Quarzglas, Borosilikatglas, Kalk-Natron-Glas, oder klare Kunststoffe, vorzugsweise starre klare Kunststoffe, insbesondere Polyethylen, Polypropylen, Polycarbonat, Polymethylmethacrylat, Polystyrol, Polyamid, Polyester, Polyvinylchlorid und/oder Gemische davon oder eine Verbundsicherheitsscheibe mit einer oder mehreren thermoplastischen Zwischenschichten enthalten.

5. Isolierglasscheibe (1) nach einem der Ansprüche 1 bis 4, wobei sich die transparente, elektrisch leitfähige Schicht (6) auf mindestens 50%, bevorzugt auf mindestens 70% und insbesondere mindestens 90% der Fläche mindestens einer der Innenseiten (II, III) der ersten Scheibe (2) oder der zweiten Scheibe (3) erstreckt.

6. Isolierglasscheibe (1) nach einem der Ansprüche 1 bis 5, wobei die transparente, elektrisch leitfähige Schicht mindestens ein Metall enthält, bevorzugt Silber, Nickel, Chrom, Niob, Zinn, Titan, Kupfer, Palladium, Zink, Gold, Cadmium, Aluminium, Silizium, Wolfram oder Legierungen daraus, und/oder mindestens ein Metalloxidschicht, bevorzugt Zinn-dotiertes Indiumoxid (ITO), Aluminium-dotiertes Zinkoxid (AZO), Fluor-dotiertes Zinnoxid (FTO, SnO₂:F), Antimon-dotiertes Zinnoxid (ATO, SnO₂:Sb), und/oder Kohlenstoffnanoröhrchen und/oder optisch transparente, elektrisch leitfähige Polymere, bevorzugt Poly(3,4-ethylenedioxythiophene), Polystyrensulfonat, Poly(4,4-dioctylcylopentadithiophen), 2,3-Dichloro-5,6-dicyano-1,4-benzoquinon, Gemische und/oder Copolymere davon.

7. Isolierglasscheibe (1) nach einem der Ansprüche 1 bis 6, wobei die transparente, elektrisch leitfähige Schicht einen Flächenwiderstand von 0,1 Ohm/Quadrat bis 200 Ohm/Quadrat, bevorzugt 1 Ohm/Quadrat bis 50 Ohm/Quadrat und besonders bevorzugt 1 Ohm/Quadrat bis 10 Ohm/Quadrat aufweist.

8. Isolierglasscheibe (1) nach einem der Ansprüche 1 bis 7, wobei die transparente, elektrisch leitfähige Schicht (6) mindestens zwei voneinander elektrisch isolierte Bereiche (6.1, 6.2) aufweist, die mit jeweils einer Schaltungsanordnung (7) für einen kapazitiven Schalter galvanisch oder kapazitiv verbunden sind.

9. Isolierglasscheibe (1) nach einem der Ansprüche 1 bis 8, wobei die Schaltungsanordnung (7) über eine Flächenelektrode (10) mit der transparenten, elektrisch leitenden Schicht (6) galvanisch verbunden ist.

10. Isolierglasscheibe (1) nach einem der Ansprüche 1 bis 8, wobei die Schaltungsanordnung (7) über eine Flächenelektrode (10) mit der transparenten, elektrisch leitenden Schicht (6) kapazitiv verbunden ist und der Abstand zwischen der Flächenelektrode (10) und der transparenten, elektrisch leitenden Schicht (6) bevorzugt von 0,01 mm bis 20 mm, besonders bevorzugt von 0,2 mm bis 10 mm, ganz besonders bevorzugt von 0,2 mm bis 1 mm beträgt.

11. Verfahren zur Herstellung einer Isolierglasscheibe (1) umfassend:
a. Beschichten einer ersten Scheibe (2) und/oder zweiten Scheibe (3) mit einer transparenten, elektrisch leitfähigen Schicht (6),
b. Verbinden einer Schaltungsanordnung (7) mit der transparenten, elektrisch leitfähigen Schicht (6) galvanisch oder durch eine Flächenelektrode (10) kapazitiv, wobei die Schaltungsanordnung (7) eine Kapazitätsänderung der transparenten, elektrisch leitfähigen Schicht (7) gegen Erde messen und bei Überschreiten eines Schwellwerts ein Schaltsignal auslösen kann,
c. Halten der zweiten Scheibe (3) und der ersten Scheibe (2) durch Abstandshalter (4) auf einem definierten Abstand, wobei die Schaltungsanordnung (7) zwischen der ersten Scheibe (2) und der zweiten Scheibe (3) angeordnet wird und
d. Versiegeln eines umlaufenden Spalts (8) zwischen der ersten Scheibe (2) und der zweiten Scheibe (3) mit einer Randversiegelung (5).

12. Verfahren zur Herstellung einer Isolierglasscheibe (1) nach Anspruch 11, wobei im Schritt (a) eine Innenseite (II, III) einer der Scheiben (2, 3) mit einer transparenten, elektrisch leitfähigen Schicht (6) beschichtet wird.

13. Verfahren zur Herstellung einer Isolierglasscheibe (1) nach einem der Ansprüche 11 bis 12, wobei im Schritt (c) die zweite Scheibe (3) mit der ersten Scheibe (2) über U-profilförmige Abstandshalter auf einem definierten Abstand gehalten werden und im Schritt (d) der äußere Hohlraum durch die Randversiegelung gefüllt wird.

14. Verwendung der Isolierglasscheibe (1) nach einen der Ansprüche 1 bis 10 als funktionales und/oder dekoratives Einzelstück und/oder als Einbauteil in Möbeln und Geräten, insbesondere elektronischen Geräten mit Kühl- oder Heizfunktion, zur Verglasung von Gebäuden, insbesondere im Zugangs- oder Fensterbereich, oder zur Verglasung in einem Fahrzeug für den Verkehr auf dem Lande, in der Luft oder zu Wasser, insbesondere in Kraftfahrzeugen, beispielsweise als Fahrzeugtür, in Bussen, Straßenbahnen, U-Bahnen, Zügen für den Personenverkehr.

## Claims

1. Insulating glass pane (1) with a capacitive switch, comprising:
- a first pane (2) and a second pane (3) which are connected to one another,
wherein the two panes (2, 3) are kept at a distance by means of spacers (4),
wherein a hollow intermediate space (13) is located between the two panes (2, 3),
- at least one transparent, electrically conductive layer (6), which is arranged at least partially and at least on one of the respective other panes (2, 3), adjacent to the inner side (II, III) of the first pane (2) or of the second pane (3), and
- at least one circuit arrangement (7), which is mounted between the first pane (2) and the second pane (3),
wherein the circuit arrangement (7) for forming the capacitive switch is galvanically connected to the transparent electrically conductive layer (6), or is capacitively coupled to the transparent, electrically conductive layer (6) by means of a surface electrode (10), wherein the circuit arrangement (7) can measure a change in capacitance against mass of the transparent electrically conductive layer (6) and can trigger a switching signal if a threshold value is exceeded.

2. Insulating glass pane (1) according to claim 1, wherein the intermediate space (13) contains a gas or a gas mixture and preferably dried air, argon or krypton, and the distance between the first pane (2) and the second pane (3) is preferably from 5 mm to 20 mm and particularly preferably from 10 mm to 15 mm.

3. Insulating glass pane (1) according to one of claims 1 through 2, wherein an edge seal (5) seals the circumferential gap (8) between the first pane (2) and the second pane (3).

4. Insulating glass pane (1) according to one of claims 1 through 3, wherein the first pane (2) and/or the second pane (3) contain pre-tensioned, partially pre-tensioned or non-prestressed glass, particularly preferably flat glass, float glass, quartz glass, borosilicate glass, soda-lime glass, or clear plastics, preferably rigid clear plastics, in particular polyethylene, polypropylene, polycarbonate, polymethyl methacrylate, polystyrene, polyamide, polyester, polyvinyl chloride and/or mixtures thereof or a composite safety pane having one or more thermoplastic intermediate layers.

5. Insulating glass pane (1) according to one of claims 1 through 4, wherein the transparent, electrically conductive layer (6) extends to at least 50%, preferably to at least 70% and in particular to at least 90% of the area of at least one of the inner sides (II, III) of the first pane (2) or of the second pane (3).

6. Insulating glass pane (1) according to one of claims 1 through 5, wherein the transparent, electrically conductive layer contains at least one metal, preferably silver, nickel, chromium, niobium, tin, titanium, copper, palladium, zinc, gold, cadmium, aluminum, silicon, tungsten or alloys thereof, and/or at least one metal oxide layer, preferably tin-doped indium oxide (ITO), aluminium-doped zinc oxide (AZO), fluorine-doped tin oxide (FTO, SnO₂:F), antimony-doped tin oxide (ATO, SnO₂:Sb), and/or carbon nanotubes and/or optically transparent, electrically conductive polymers, preferably poly (3,4-ethylenedioxythiophenes), polystyrene sulfonate, poly (4,4-dioctylcyclopentadithiophene), 2,3-dichloro -5,6-dicyano-1,4-benzoquinone, mixtures and/or copolymers thereof.

7. Insulating glass pane (1) according to one of claims 1 through 6, wherein the transparent, electrically conductive layer has a surface resistance of 0.1 ohm/square to 200 ohm/square, preferably 1 ohm/square to 50 ohm/square and particularly preferably 1 ohm/square to 10 ohm/square.

8. Insulating glass pane (1) according to one of claims 1 through 7, wherein the transparent, electrically conductive layer (6) has at least two regions (6.1, 6.2) which are electrically insulated from one another and are galvanically or capacitively connected to a respective circuit arrangement (7) for a capacitive switch.

9. Insulating glass pane (1) according to one of claims 1 through 8, wherein the circuit arrangement (7) is galvanically connected to the transparent, electrically conductive layer (6) via a surface electrode (10).

10. Insulating glass pane (1) according to one of claims 1 to 8, wherein the circuit arrangement (7) is capacitively connected to the transparent, electrically conductive layer (6) via a surface electrode (10), and the distance between the surface electrode (10) and the transparent, electrically conductive layer (6) is preferably from 0.01 mm to 20 mm, particularly preferably from 0.2 mm to 10 mm, very particularly preferably from 0.2 mm to 1 mm.

11. Method for producing an insulating glass pane (1), comprising:
a. coating of a first pane (2) and/or second pane (3) with a transparent, electrically conductive layer (6),
b. connecting a circuit arrangement (7) to the transparent, electrically conductive layer (6) galvanically or capacitively by means of a surface electrode (10), wherein the circuit arrangement (7) can measure a change in capacitance of the transparent electrically conductive layer (7) against mass and can trigger a switching signal when a threshold value is exceeded,
c. holding the second pane (3) and the first pane (2) at a defined distance by means of spacers (4), wherein the circuit arrangement (7) is arranged between the first pane (2) and the second pane (3), and
d. sealing of a circumferential gap (8) between the first pane (2) and the second pane (3) with an edge seal (5).

12. Method for producing an insulating glass pane (1) according to claim 11, wherein in step (a) an inner side (II, III) of one of the panes (2, 3) is coated with a transparent, electrically conductive layer (6).

13. Method for producing an insulating glass pane (1) according to one of claims 11 through 12, wherein in step (c) the second pane (3) and the first pane (2) are held at a defined distance by means of U-profile-shaped spacers and in step (d) the outer cavity is filled by the edge seal.

14. Use of the insulating glass pane according to one of claims 1 through 10 as functional and/or decorative single piece and/or as a built-in part in furniture and devices, in particular electronic devices having a cooling or heating function, for glazing buildings, in particular in the access or window area, or for glazing in a vehicle for the traffic on the land, in the air or in water, in particular in motor vehicles, for example as a vehicle door, in buses, trams, underground railways, trains for passenger traffic.

## Revendications

1. Vitrage isolant (1) avec un commutateur capacitif, comprenant :
- une première vitre (2) et une deuxième vitre (3), qui sont reliées entre elles, où les deux vitres (2, 3) sont maintenues à distance par des cales d'espacement (4), où un espace creux (13) se trouve entre les deux vitres (2, 3),
- au moins une couche transparente, électriquement conductrice (6), qui est installée au moins partiellement et au moins sur l'une des faces intérieures (II, III) de la première vitre (2) ou de la deuxième vitre (3), tournées respectivement vers l'autre vitre (2, 3) et
- au moins un dispositif de circuit (7), qui est installé entre la première vitre (2) et la deuxième vitre (3),
où le dispositif de circuit (7) pour former le commutateur capacitif est relié de manière galvanique avec la couche électriquement conductrice transparente (6), ou est couplée de manière capacitive par une électrode de surface (10) avec la couche conductrice transparente (6), où le dispositif de circuit (7) peut mesurer un changement dans la capacité de la couche transparente, électriquement conductrice (6) par rapport à la terre et peut déclencher un signal de commutation lorsqu'un seuil est dépassé.

2. Vitrage isolant (1) selon la revendication 1, où l'espace creux (13) contient un gaz ou un mélange de gaz et de préférence de l'air séché, de l'argon ou du krypton, et la distance entre la première vitre (2) et la deuxième vitre (3) est de préférence de 5 mm à 20 mm et de façon particulièrement préférée est de 10 mm à 15 mm.

3. Vitrage isolant (1) selon l'une des revendications 1 ou 2, où une bordure d'étanchéité (5) scelle l'écart circonférentielle (8) entre la première vitre (2) et la deuxième vitre (3).

4. Vitrage isolant (1) selon l'une des revendications 1 à 3, où la première vitre (2) ou la deuxième vitre (3) contient du verre trempé, renforcé à la chaleur ou non trempé, de façon particulièrement préférée du verre plat, du verre flotté, du verre de quartz, du verre borosilicaté, du verre sodocalcique, ou des plastiques claires, de préférence des plastiques claires rigides, en particulier du polyéthylène, du polypropylène, du polycarbonate, du polyméthacrylate de méthyle, du polystyrène, du polyamide, du polyester, du polychlorure de vinyle et/ou des mélanges de ceux-ci, ou un vitrage feuilleté de sécurité avec une ou plusieurs couches intermédiaires thermoplastiques.

5. Vitrage isolant (1) selon l'une des revendications 1 à 4, où la couche transparente, électriquement conductrice (6) s'étend sur au moins 50%, de préférence sur au moins 70%, et en particulier sur au moins 90% de la surface d'au moins l'une des faces intérieures (II, III) de la première vitre (2) ou de la deuxième vitre (3).

6. Vitrage isolant (1) selon l'une des revendications 1 à 5, où la couche conductrice transparente contient au moins un métal, de préférence de l'argent, du nickel, du chrome, du niobium, de l'étain, du titane, du cuivre, du palladium, de l'or, du cadmium, du zinc, de l'aluminium, du silicium, du tungstène ou des alliages de ceux-ci, et/ou au moins une couche d'oxyde métallique de préférence de l'oxyde d'Indium dopé à l'étain (ITO), de l'oxyde de zinc dopé à l'aluminium (AZO), de l'oxyde d'étain dopé au fluor (FTO, SnO₂: F), de l'oxyde d'étain dopé à l'antimoine (ATO, SnO₂ : SB), et/ou des nanotubes de carbone ,et/ou des polymères optiquement transparents, conducteurs d'électricité, de préférence du poly(3,4-éthylène-dioxythiophène), du sulfonate de polystyrène, du poly(4,4-dioctylcylopentadithiophène), du 2,3 Dichloro-5,6-dicyano-1,4-benzoquinone, des mélanges et/ou des copolymères de ceux-ci.

7. Vitrage isolant (1) selon l'une des revendications 1 à 6, où la couche transparente, électriquement conductrice possède une résistance de surface de 0,1 ohm / carré à 200 ohms / carré, de préférence de 1 ohm / carré jusqu'à 50 Ohms / carré et de manière particulièrement préféré 1 ohm/carré à 10 Ohm / carré.

8. Vitrage isolant (1) selon l'une des revendications 1 à 7, où la couche transparente, électriquement conductrice (6) possède au moins deux zones (6.1, 6.2) isolées électriquement l'une de l'autre, dont chacune est reliée de manière galvanique ou capacitive à un dispositif de circuit (7) pour un commutateur capacitif.

9. Vitrage isolant (1) selon l'une des revendications 1 à 8, où le dispositif de circuit (7) est relié de manière galvanique avec la couche transparente, électriquement conductrice (6) par une électrode de surface (10).

10. Vitrage isolant (1) selon l'une des revendications 1 à 8, où le dispositif de circuit (7) est relié de manière capacitive avec la couche transparente, électriquement conductrice (6) par une électrode de surface (10) et la distance entre l'électrode de surface (10) et la couche transparente et conductrice (6) est de préférence de 0,01 mm à 20 mm, de manière particulièrement préférée de 0,2 mm à 10 mm, et de manière très particulièrement préférée de 0,2 mm à 1 mm.

11. Procédure de fabrication d'un vitrage isolant (1) comprenant:
a. le dépôt d'une couche transparente, électriquement conductrice (6) sur une première vitre (2) ou une deuxième vitre (3)
b. la connexion d'un dispositif de commutation (7) avec la couche transparente, électriquement conductrice (6) sur une première vitre (2) ou une deuxième vitre (3) de manière galvanique ou, par le biais d'une électrode de surface (10), de manière capacitive, où le dispositif de circuit (7) peut mesurer un changement dans la capacité de la couche transparente, électriquement conductrice (5) par rapport à la terre et peut déclencher un signal de commutation lorsqu'un seuil est dépassé,
c. le maintien d'un écart défini entre la deuxième vitre (3) et la première vitre (2) par le biais de cales d'espacement (4), où le dispositif de circuit (7) est disposé entre la première vitre (2) et la deuxième vitre (3), et
d. le scellage de l'écart circonférentielle (8) entre la première vitre (2) et la deuxième vitre (3) avec une bordure d'étanchéité (5).

12. Méthode de production d'un vitrage isolant (1) selon la revendication 11, où lors de l'étape (a) une face intérieure (II, III) d'une des vitres (2, 3) est recouvert d'une couche transparente, électriquement conductrice (6).

13. Méthode de production d'un vitrage isolant (1) selon l'une des revendications 11 et 12, où lors de l'étape (c) la deuxième vitre (3) est reliée avec la première vitre (2) par des cales d'espacement de profilé en U avec un écart définie, et à l'étape (d) l'espace creux extérieure est rempli par la bordure d'étanchéité.

14. Utilisation d'un vitrage isolant (1) selon l'une des revendications 1 à 10, comme pièce fonctionnelle ou décorative, et/ou comme composant dans les meubles et les appareils, en particulier les équipements électroniques avec une fonction de refroidissement ou de chauffage, pour les vitrages des bâtiments, en particulier dans les zones d'accès ou des fenêtres, ou pour le vitrage dans un véhicule pour le transport sur la terre, dans l'air ou dans l'eau, en particulier dans les véhicules automobiles, par exemple comme porte d'un véhicule, dans les bus, les tramways, les métros, les trains ou pour le transport de passagers.
